# EUROPEAN PATENT APPLICATION

(11) **EP 4 535 827 A1**
(43) Date of publication of application: **09.04.2025**
(21) Application number: 23830486.9
(22) Date of filing: 30.06.2023
(51) Int. Cl.: H04R 17/00

(54) **PIEZOELECTRIC VIBRATION SENSING UNIT AND ELECTRONIC DEVICE**

(30) Priority: 30.06.2022 CN 202210756777; 13.12.2022 CN 202211600980
(71) Applicant: Huawei Technologies Co., Ltd., Shenzhen, Guangdong 518129 (CN)
(72) Inventor: XING, Zengping, Shenzhen, Guangdong 518129 (CN); RUAN, Shengjie, Shenzhen, Guangdong 518129 (CN)
(74) Representative: Goddar, Heinz J.
(86) International application number: PCT/CN2023/104464
(87) International publication number: WO 2024/002322

(57) **Abstract**

This application relates to the field of acoustoelectronics, the field of audio devices, and the field of multimedia devices, and in particular, to noise reduction in a mobile application scenario, for example, a hearing aid, a headset, and smart glasses, and is responsible for conduction and noise reduction of various sounds. This application describes a piezoelectric vibration sensing unit and an electronic device. The piezoelectric vibration sensing unit includes a base, a plurality of cantilevers, a central film, a connection part, and a mass block. A piezoelectric structure of the piezoelectric vibration sensing unit is based on a VPU design of strong coupling between unequal-length piezoelectric cantilevers and a film. The design aims to overcome disadvantages of a gradually decreasing response at a low frequency and insufficient bandwidth.

## Description

### TECHNICAL FIELD

This application relates to the field of acoustoelectronics, the field of audio devices, and the field of multimedia devices, and in particular, to a piezoelectric vibration sensing unit and an electronic device.

### BACKGROUND

A voice pick-up bone sensor (Voice Pick-up Bone sensor, VPU for short) collects vibration of a human head, and cooperates with air conduction, to filter out ambient noise according to a related algorithm. This achieves a good fidelity effect.

Currently, there are two types of VPUs: analog VPUs and digital VPUs. Most of the digital VPUs use capacitive sensing, which has a good sensing effect and a strong anti-noise capability, but also has a disadvantage of high power consumption. Power consumption is a key to a battery life of a wearable device. The analog VPUs become a mainstream application product because of an advantage of low power consumption of the analog VPUs.

Therefore, performance optimization of the analog VPUs is always a hot research topic for persons skilled in the art.

### SUMMARY

Embodiments of this application describe a piezoelectric vibration sensing unit and an electronic device. The apparatus includes a base, a plurality of cantilevers, a central film, a connection part, and a mass block. A piezoelectric structure of the piezoelectric vibration sensing unit is based on a VPU design of strong coupling between unequal-length piezoelectric cantilevers and a film. The design aims to overcome disadvantages of a gradually decreasing response at a low frequency and insufficient bandwidth.

According to one aspect, an embodiment of this application provides a piezoelectric vibration sensing unit apparatus. The apparatus includes a base, where a central part of the base is of a hollow structure; a plurality of cantilevers, where equivalent lengths of any two of the cantilevers are unequal for bandwidth extension and subsequent resonance suppression of the cantilevers, one end of each of the plurality of cantilevers is fastened to the base, and the other end of each of the plurality of cantilevers extends to the hollow structure of the base; a central film, where a projection of the central film on the base is located in a projection of the hollow structure on the base; a connection part, where the plurality of cantilevers are rigidly connected to the central film through the connection part; and a mass block, where the mass block is connected to the central film.

The plurality of cantilevers with different effective lengths have a plurality of different resonance frequencies, and are rigidly and strongly coupled to each other through the central film, so that a resonance frequency of each cantilever is suppressed, thereby expanding a frequency band of the entire piezoelectric vibration sensing unit.

In a possible design, stiffness of the connection part is greater than 20% of stiffness of the cantilever.

In a possible design, a difference between equivalent lengths of the cantilevers is at least 10%, which has an ideal effect. If the difference between the equivalent lengths of the cantilevers is less than 10%, but resonance suppression can be achieved, the effect may also be good.

In a possible design, a Young's modulus of the connection part is greater than 200 MPa.

In a possible design, the cantilevers may have unequal widths in an extension direction.

In a possible design, at least one of the plurality of cantilevers has a hollow-out pattern. Such a design can release stress in a thin film processing process.

In a possible design, the central film and the mass block form an integrated structure.

In a possible design, at least two of the central film, the connection part, and the plurality of cantilevers are integrally formed.

In a possible design, the mass block is located on a surface of a side that is of the central film and that is away from the base, or the mass block is located on a surface of a side that is of the central film and that faces the base.

In a possible design, the piezoelectric vibration sensing unit includes a plurality of piezoelectric sensing layers, and the piezoelectric sensing layers are disposed on the cantilevers.

In a possible design, at least two of the plurality of piezoelectric sensing layers are electrically connected.

In a possible design, the piezoelectric vibration sensing unit further includes a first damping layer and a second damping layer. The first damping layer is located on a side that is of the cantilevers and that is away from the piezoelectric sensing layer, and/or the second damping layer is located on a side that is of the piezoelectric sensing layer and that is away from the cantilevers. The first damping layer and the second damping layer cover the cantilevers, to reduce a mechanical quality factor q value, expand a frequency band, and implement a specific impact-resistant protection function.

In a possible design, the piezoelectric vibration sensing unit further includes a third damping layer. The third damping layer is located on a side that is of the mass block and that is away from the cantilevers, and there is a gap between the third damping layer and the mass block. A surface that is of the third damping layer and that faces the mass block is a non-adhesive surface, to avoid damage to a device when the cantilevers and the mass block above the cantilevers vibrate greatly, so that the third damping layer is used to protect the device from impact. The non-adhesive processing is to prevent the third damping layer from being bonded to the mass block, which affects subsequent normal operation of the device.

According to another aspect, an electronic device is provided, including the foregoing piezoelectric vibration sensing unit and an application-specific integrated circuit device. The piezoelectric vibration sensing unit is electrically connected to the application-specific integrated circuit device.

### BRIEF DESCRIPTION OF DRAWINGS

The following describes in more details embodiments of the present invention with reference to accompanying drawings.
FIG. 1A is a diagram of a system architecture of a VPU;
FIG. 1B is a top view of a piezoelectric sensing unit;
FIG. 2 is a top view of a base;
FIG. 3 is a cross-sectional view of an equal-width double-cantilever structure;
FIG. 4 is a top view of an equal-width double-cantilever structure;
FIG. 5A is a top view of an unequal-width cantilever structure;
FIG. 5B is a c top view of an unequal-width cantilever structure; and
FIG. 6 is a top view of a plurality of composite cantilever structures.

### Reference numerals:

1: piezoelectric sensing unit;
12: cantilever;
121: gap;
13: piezoelectric sensing layer;
14: central film;
15: output electrode;
16: mass block;
17: connection part;
18: first damping layer;
19: third damping layer;
2: application-specific integrated circuit;
3: printed circuit board;
4: hollow structure; and
5: base.

### DESCRIPTION OF EMBODIMENTS

The system apparatus described in embodiments of this application is intended to describe the technical solutions in embodiments of this application more clearly, but constitute no limitation on the technical solutions provided in embodiments of this application.

In a call, during voice uploading, a voice receiver not only receives a voice, but also collects and uploads noise in an ambient environment (noisy crowd, device noise, and wind and rain noise). Uplink noise reduction uses a series of technical means to filter out the noise in the ambient environment as much as possible, and retain voice information of a speaker as much as possible for uploading. When a person speaks, in addition to gas vibration caused by a voice, vibration of the head is also accompanied. The vibration is collected by a bone conduction receiver, and the vibration is generally not affected by ambient noise. A voice signal is converted into a vibration signal through a bone conduction transmitter, and the vibration signal is transmitted to the auditory nerve through the periosteum. Uplink noise reduction uses this feature to reduce noise, and there are two mainstream methods. One is to collect head/throat vibration directly through bone conduction, and then transmit the vibration after simple filtering. This method is commonly used for voice transmission in an extremely noisy environment and has low requirements on fidelity. The other is that a bone conduction sensor collects vibration of a human head, and cooperates with air conduction, to filter out ambient noise according to a related algorithm.

A second type of bone conduction is also referred to as voice pick-up bone conduction (Voice Pick-up Bone sensor, VPU for short). Currently, there are two types of VPUs: analog VPUs and digital VPUs. Most of the digital VPUs use capacitive sensing, which has a good sensing effect and a strong anti-noise capability, but also has a disadvantage of high power consumption. Power consumption is a key to a battery life of a wearable device. Although the analog VPUs have a poorer effect and a weaker anti-noise capability, power consumption is extremely low. Low power consumption is mainly considered in embodiments of this application. The design is mainly for the analog VPUs.

There are mainly two forms of analog VPUs. One form is a VPU obtained by modifying a MEMS MIC (micro-electro-mechanical system microphone), where an elastic membrane and a mass block are added or modified on the MEMS MIC, and corresponding packaging processing is performed. In this method, preparation is simple, an existing process may be used, and sensitivity is high, but disadvantages are that a response gradually decreases at a low frequency and it is difficult to reduce a size. The other form is a piezoelectric analog VPU. This type of VPU does not have the problem of a response decreasing at a low frequency, but a frequency bandwidth is not satisfactory. For bone conduction and air conduction, differences between sound pressure levels of the two types of conduction are different at different frequencies. If a frequency is within 4 k, a difference between the sound pressure levels of the two types of conduction after normalization is not large. However, if a frequency exceeds 4 k, due to absorption of bone conduction vibration by human skin and soft tissues, the sound pressure level of the bone conduction is much lower than that of the air conduction.

Therefore, for a design of a VPU, in addition to sensitivity of the VPU, at least 4 k bandwidth is required in terms of performance of a frequency response. If a wider coverage is required, 10 k bandwidth is required to enable the VPU to cooperate with a microphone to improve performance in uplink noise reduction.

In view of this, persons of ordinary skill in the art may learn that, this application provides a piezoelectric vibration sensing unit and an electronic device. The electronic device may be a VPU. The electronic device provided in embodiments of this application effectively resolves a problem that a low-frequency response gradually attenuates, and a structure of strong coupling between unequal-length piezoelectric cantilevers and a central film overcomes a problem of excessively narrow frequency bandwidth in the conventional VPU design.

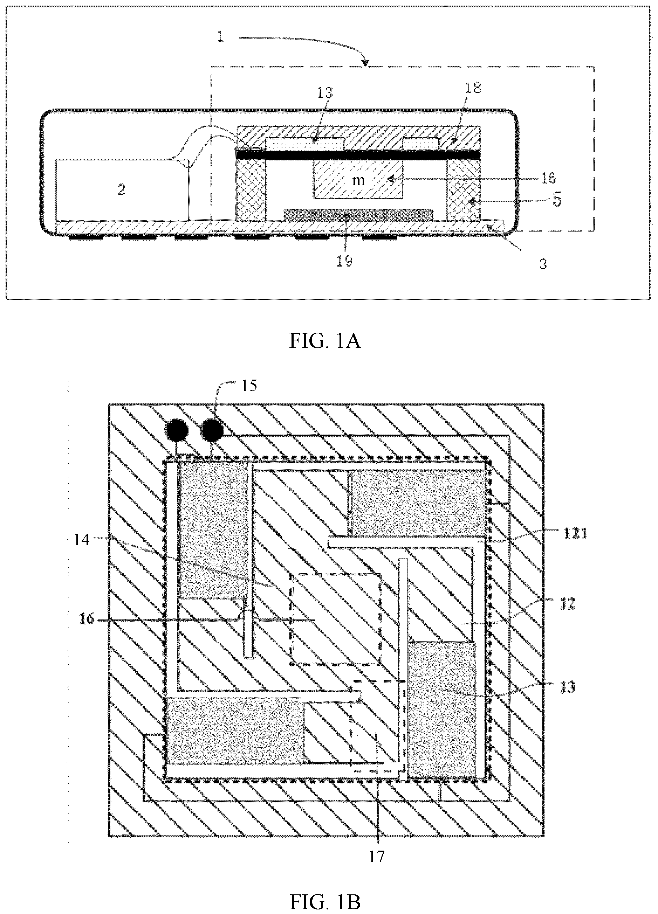

FIG. 1A is an example of a diagram of a system architecture of a VPU according to an embodiment of this application. The VPU includes: a piezoelectric vibration sensing unit; a weak signal amplification integrated circuit, configured to amplify a signal from the piezoelectric vibration sensing unit; a printed circuit board, configured to transform an input (mainly an analog parameter, a power supply input, and a communication input) and an output (a communication input and an analog parameter) of an amplified integrated circuit signal to a solder joint of the printed circuit board; and a package housing, configured to protect a housing of a sensor from impact and electromagnetic interference. The basic architecture is shown in FIG. 1A.

Embodiments of this application provide a piezoelectric vibration sensing unit and an electronic device. The apparatus includes: As shown in FIG. 1B, the piezoelectric vibration sensing unit includes a base, a plurality of cantilevers, a central film, a connection part, a mass block, a piezoelectric sensing layer, a first damping layer, a second damping layer, and a third damping layer.

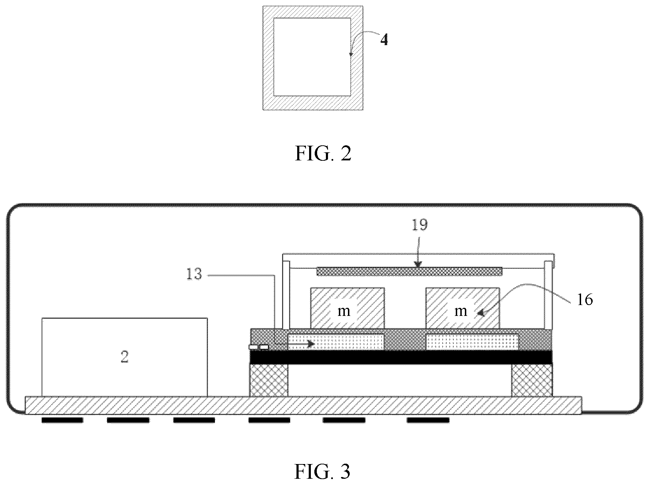

As shown in FIG. 2, in some embodiments, the base has a hollow structure, and the hollow structure part of the base is a polygonal cavity structure formed by eroding a back cavity.

Certainly, in the accompanying drawings in embodiments of this application, an example in which a contour of the hollow structure is a quadrilateral is merely used for illustration. The contour of the hollow structure may be any closed pattern, for example, a polygon, an ellipse, or a circle.

As shown in FIG. 1B, in the plurality of cantilevers included in the piezoelectric vibration sensing unit, equivalent lengths of any two cantilevers are unequal.

In FIG. 1B, an example in which the piezoelectric vibration sensing unit includes four cantilevers is used for illustration. The four cantilevers are respectively marked as a cantilever 1, a cantilever 2, a cantilever 3, and a cantilever 4.

In some embodiments, a difference between equivalent lengths of any two cantilevers is at least 10%. One end of each of the plurality of cantilevers is fastened to the base, and the other end of each of the plurality of cantilevers extends to the hollow structure of the base.

The equivalent length of the cantilever means that it is assumed that when a cantilever A is connected to a connection component, another equal-width cantilever B is also connected to the connection component, and if a resonance frequency of the cantilever A is consistent with a resonance frequency of the equal-width cantilever B, a length of the equal-width cantilever B is an equivalent length of the cantilever A.

A difference between equivalent lengths of any two cantilevers is at least 10%.

For example, the difference between the equivalent lengths of any two cantilevers may be 20%, 30%, 40%, 50%, 60%, 70%, 80%, 90%, or 100%.

In some embodiments, the cantilevers extend from a corner of the cavity along an edge of the cavity, an edge of at least one cantilever is parallel to the edge of the cavity, and the unequal-length cantilevers have different resonance frequencies.

Certainly, in embodiments of this application, the plurality of cantilevers in the piezoelectric vibration sensing unit may be two or more cantilevers, and are not limited to four cantilevers.

In some embodiments, the cantilever may extend in a form of a straight arm structure, or may extend in a bent structure or a turnback structure.

In some embodiments, there are a plurality of hollow-out patterns on the cantilever. These hollow-out patterns may be micropores, for example, circular micropores, square holes, or other irregular-shaped holes, or may be slits, where the slit may be in a straight-line elongated shape, or may be a curved zigzag shape, or the like. The hollow-out pattern on the cantilever can release stress in a thin film processing process.

In some embodiments, the base and the cantilever are an integrated structure.

A projection of the central film on the base is located in a projection of the hollow structure on the base.

The central film may be any enclosed pattern. The central film may be an irregular polygon, a square, or a circle. The central film is generally made of Si or a substrate material, and a shape of the central film is not limited. An area of the central film is as large as possible without affecting vibration of the cantilever. Because a projection of the mass block on the central film is located in the central film, when the area of the central film is as large as possible, an area of the mass block can be larger. In this case, in same mass, increasing the area of the mass block can reduce a height of the mass block, thereby improving stability of the entire device.

The piezoelectric vibration sensing unit further includes the connection part. The plurality of cantilevers are rigidly connected to the central film through the connection part.

In some embodiments, the connection part includes a plurality of connection blocks, and each cantilever is rigidly connected to the central film through one connection block.

In some embodiments, stiffness of the connection part is greater than 20% of stiffness of the cantilever.

In some embodiments, a Young's modulus of the connection part is greater than 200 MPa.

In some embodiments, the cantilever, the central film, and the connection part are integrally formed.

In some other embodiments, the cantilever, the central film, and the connection part may alternatively be separately manufactured, and finally connected through process bonding.

Effective lengths of the cantilevers are unequal. Therefore, resonance frequencies of the cantilevers are accordingly different. However, during manufacturing of the device, sensitivity needs to be stable, especially in a frequency band that can be used by the device, sensitivity is kept stable, and resonance cannot occur. If resonance occurs in the frequency band that can be used by the device, an external environmental factor (for example, a temperature) greatly affects performance of the device. For example, when the temperature changes slightly, resonance performance of the device changes, affecting stability of the device. Therefore, non-fixed ends of the plurality of cantilevers are rigidly coupled to the central film by using a first connection part. The Young's modulus of the connection part is equivalent to a Young's modulus of the piezoelectric cantilever, or the Young's modulus of the connection part is greater than 200 MPa. When a sound signal reaches a resonance frequency of a cantilever, and the cantilever resonates, another cantilever suppresses the cantilever by using the rigidly coupled central film, to suppress resonance of the cantilever, so that a resonance region is suppressed, and a use frequency of the VPU is expanded.

The piezoelectric sensing layer is located on each cantilever, and is formed by a piezoelectric material and a corresponding electrode region. The electrode region may be upper and lower electrodes, or may be an interdigital electrode.

The piezoelectric sensing layer may cover the entire cantilever, or may not cover the entire cantilever.

The piezoelectric sensing layer includes a metal electrode. The metal electrode is located on an upper end face and a lower end face in a thickness direction of the piezoelectric film. Corresponding electrodes are electrically connected in series and in parallel through a connection line, and are finally output as two electrodes. The electrodes are configured to collect charges in a piezoelectric region, and electrode cables are used to connect the plurality of cantilevers in series and parallel. The piezoelectric sensing layer may be used for outputting separately, or may be used for outputting by units in an array in series, in parallel, or in series and parallel.

The mass block is connected to the central film. The mass block may be located on a side that is of the central film and that is away from the base, as shown in FIG. 1A, or may be located on a side that is of the central film and that faces the base, as shown in FIG. 3.

The mass block may be an entire block, or may be a distributed mass unit including a plurality of mass blocks. Generally, a plurality of distributed mass blocks have a better effect, which can effectively avoid a stress concentration problem. A size, a shape, and a quantity of the mass blocks are not limited.

In some embodiments, as shown in FIG. 1A, the piezoelectric vibration sensing unit further includes the first damping layer and the second damping layer, the first damping layer is sprayed on a cantilever layer and the piezoelectric sensing layer with omnidirectional coverage, the second damping layer is sprayed below the cantilever layer and a mass block layer with omnidirectional coverage, or may be sprayed on and below all process film layers with omnidirectional coverage. Alternatively, the first damping layer and the second damping layer are sprayed on a part of the process film layers. Generally, the first damping layer and the second damping layer are usually sprayed for covering in the last process step of the piezoelectric vibration sensing unit.

In some embodiments, the piezoelectric vibration sensing unit further includes the third damping layer, the third damping layer is located below a mass block m, and a specific gap is reserved between the third damping layer and the mass block m. Debonding is performed on a surface of the third damping layer. As shown in FIG. 1A, when a vibration amplitude of the cantilever and the mass block below the cantilever is excessively large, the cantilever and the mass block are damaged. Therefore, the third damping layer is sprayed to prevent a reliability problem. In addition, debonding processing needs to be performed on the third damping layer, to prevent the mass block from being bonded to the third damping layer when the cantilever vibrates, which causes a case in which the component cannot operate.

The damping layer is located at outer edges of all process film layers, and may cover a slot part, to further suppress the resonance. Because a resonance peak on a spectrum is excessively sharp, and a quality factor is excessively high, a frequency response near a resonance frequency is unstable, and the quality factor can be reduced by using a damping technology.

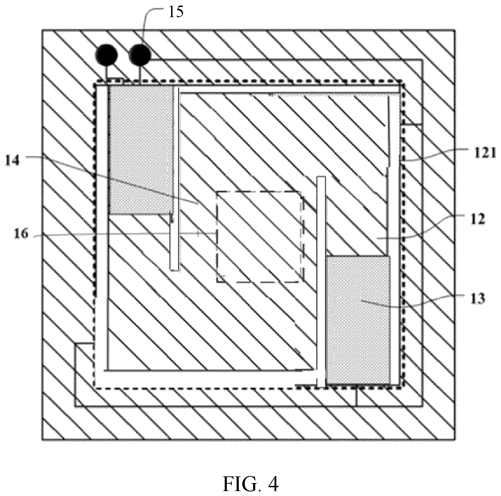

Similar to the solution 1, the solution 2 includes two equal-width cantilevers. As shown in FIG. 3 and FIG. 4, upper and lower edges of the equal-width cantilever are parallel, all widths from a root part to a tail part are the same, and there are also two mass blocks. An advantage of two cantilevers over four cantilevers is that each cantilever can be made comparatively wide.

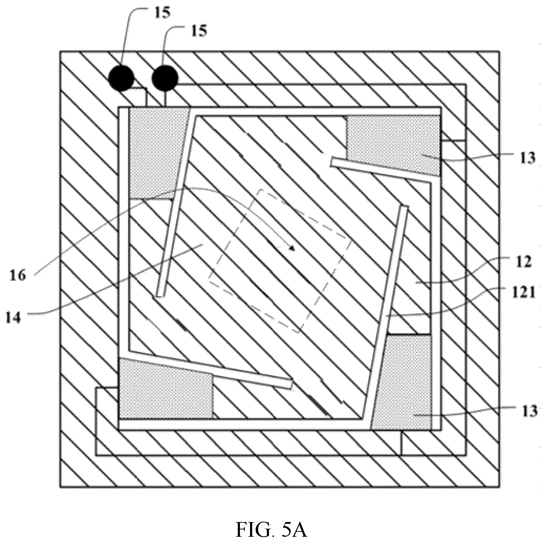

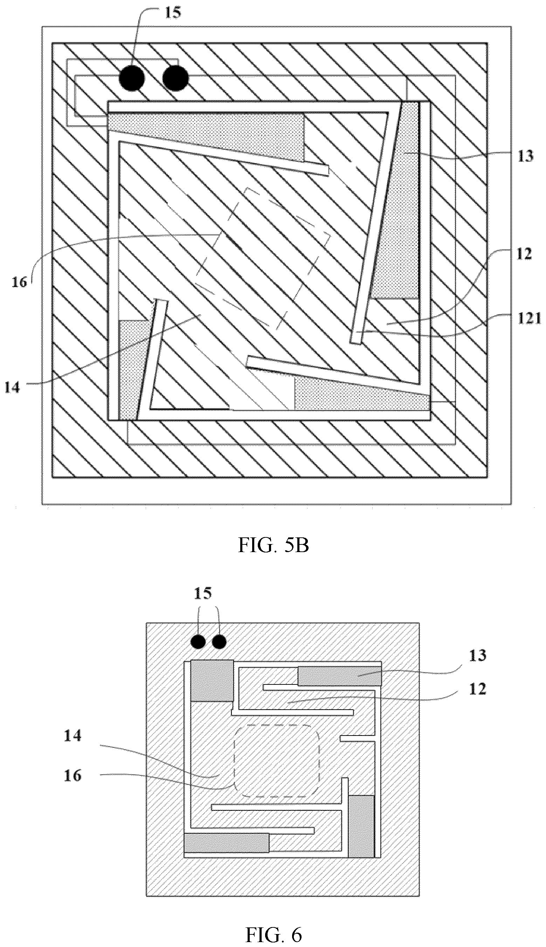

Similar to the solution 1, the solution 3 uses an unequal-width cantilever. As shown in FIG. 5A and FIG. 5B, widths of the root part and the tail part are different. There are two possible cases. One is that the root part of the cantilever is narrow and the tail part is wide. This type of cantilever is made into a sensor, so that sensitivity of the device is high, but reliability is poor. The other is that the root part is wide, and the tail part is narrow, so that reliability is high. In addition, some holes are selectively opened in the middle of the central film, to eliminate some stress.

The solution 4 is composition of a plurality of types of cantilevers. As shown in FIG. 6, the cantilevers include short and long arms, a turnback arm, a bent arm, and the like.

The objectives, technical solutions, and benefits of the present invention are further described in detail in the foregoing specific embodiments. It should be understood that the foregoing descriptions are merely specific embodiments of the present invention, but are not intended to limit the protection scope of the present invention. Any modification, equivalent replacement, or improvement made within the spirit and principle of the present invention shall fall within the protection scope of the present invention.

## Claims

1. A piezoelectric vibration sensing unit, wherein the piezoelectric vibration sensing unit comprises:
a base, wherein a central part of the base is of a hollow structure;
a plurality of cantilevers, wherein equivalent lengths of any two of the cantilevers are unequal for bandwidth extension and resonance suppression of the cantilevers; one end of each of the plurality of cantilevers is fastened to the base; and the other end of each of the plurality of cantilevers extends to the hollow structure of the base;
a central film, wherein a projection of the central film on the base is located in a projection of the hollow structure on the base;
a connection part, wherein the plurality of cantilevers are rigidly connected to the central film through the connection part; and
a mass block, wherein the mass block is connected to the central film.

2. The piezoelectric vibration sensing unit according to claim 1, wherein stiffness of the connection part is greater than 20% of stiffness of the cantilever.

3. The piezoelectric vibration sensing unit according to claim 1, wherein a difference between equivalent lengths of the cantilevers is greater than 10%.

4. The piezoelectric vibration sensing unit according to claim 1 or 2, wherein a Young's modulus of the connection part is greater than 200 MPa.

5. The piezoelectric vibration sensing unit according to any one of claims 1 to 3, wherein the cantilevers have unequal widths in an extension direction of the cantilevers.

6. The piezoelectric vibration sensing unit according to any one of claims 1 to 4, wherein at least one of the plurality of cantilevers has a hollow-out pattern.

7. The piezoelectric vibration sensing unit according to any one of claims 1 to 5, wherein at least two of the central film, the connection part, and the plurality of cantilevers are integrally formed.

8. The piezoelectric vibration sensing unit according to any one of claims 1 to 6, wherein the central film and the mass block form an integrated structure.

9. The piezoelectric vibration sensing unit according to any one of claims 1 to 8, wherein the mass block is located on a surface of a side that is of the central film and that is away from the base, or the mass block is located on a surface of a side that is of the central film and that faces the base.

10. The piezoelectric vibration sensing unit according to any one of claims 1 to 9, wherein the piezoelectric vibration sensing unit further comprises a plurality of piezoelectric sensing layers, and the piezoelectric sensing layers are disposed on the cantilevers.

11. The piezoelectric vibration sensing unit according to claim 10, wherein at least two of the plurality of piezoelectric sensing layers are electrically connected.

12. The piezoelectric vibration sensing unit according to any one of claims 1 to 11, wherein the piezoelectric vibration sensing unit further comprises a first damping layer, the first damping layer is located on a side that is of the cantilevers and that is away from the piezoelectric sensing layer, and the first damping layer covers a part or all of the cantilevers; and/or the piezoelectric vibration sensing unit further comprises a second damping layer, and the second damping layer is located on a side that is of the piezoelectric sensing layer and that is away from the cantilevers.

13. The piezoelectric vibration sensing unit according to any one of claims 1 to 12, wherein the piezoelectric vibration sensing unit further comprises a third damping layer, the third damping layer is located on a side that is of the mass block and that is away from the cantilevers, there is a gap between the third damping layer and the mass block, and a surface that is of the third damping layer and that faces the mass block is a non-adhesive surface.

14. An electronic device, comprising the piezoelectric vibration sensing unit according to any one of claims 1 to 12 and an application-specific integrated circuit device, wherein the piezoelectric vibration sensing unit is electrically connected to the application-specific integrated circuit.
